# EUROPÄISCHE PATENTSCHRIFT

(11) **EP 0 755 078 B1**
(45) Veröffentlichungstag und Bekanntmachung des Hinweises auf die Patenterteilung: **05.09.2001**
(21) Anmeldenummer: 96110021.1
(22) Anmeldetag: 21.06.1996
(51) Int. Cl.: H01L 29/872, H01L 21/329

(54) **Metall-Halbleiterkontakt**
Metal semiconductor contact
Contact métal-semiconducteur

(30) Priorität: 21.07.1995 DE 19526739
(43) Veröffentlichungstag der Anmeldung: 22.01.1997
(73) Patentinhaber: General Semiconductor Ireland, Macroom, County Cork (IE)
(72) Erfinder: Igel, Günter, Dipl.-Ing., 79312 Emmendingen (DE)
(74) Vertreter: Menges, Rolf, Dipl.-Ing.

(56) Entgegenhaltungen:
- US-A- 3 657 615
- US-A- 3 762 945
- US-A- 3 891 479
- US-A- 3 904 449
- IEEE TRANSACTIONS ON MICROWAVE THEORY AND TECHNIQUES, Bd. 42, Nr. 12, 1.Dezember 1994, Seiten 2504-2511, XP000486996 GEARHART S S ET AL: "A MONOLITHIC 250 GHZ SCHOTTKY-DIODE RECEIVER"
- PATENT ABSTRACTS OF JAPAN vol. 006, no. 107 (E-113), 17.Juni 1982 & JP-A-57 037886 (HITACHI LTD), 2.März 1982,

## Beschreibung

Die Erfindung betrifft ein Halbleiterbauelement mit einem Halbleitersubstrat und einer darauf aufgebrachten Epitaxieschicht, auf welcher eine strukturierte Isolierschicht und darüber eine Metallschicht derart angeordnet sind, daß die Metallschicht mit der Epitaxieschicht einen Metall-Halbleiterkontakt bildet.

Solche Halbleiterbauelemente finden ihre Anwendung insbesondere als Schottky-Dioden. Sie werden beispielsweise als Schaltelemente zur Realisierung sehr kurzer Schaltzeiten verwendet. Diese Eigenschaften der Schottky-Dioden sind bei der Entwicklung von Stromversorgungen, die einen hohen Wirkungsgrad, hohe Zuverlässigkeit und möglichst geringe elektromagnetische Störungen aufweisen sollen, sehr wesentlich. Sie werden beispielsweise für die Stromversorgungen im Telekom-Bereich verwendet. Die Anforderungen an die Eigenschaften der Schottky-Dioden steigen ständig an, so daß eine Verbesserung gewünscht wird.

Es ist wünschenswert, daß sie eine möglichst niedrige Kapazität aufweisen, da dadurch die Schaltzeit, welche umgekehrt proportional zur Kapazität ist, verkleinert werden kann. Ferner ist ein möglichst niedriger Sperrstrom wünschenswert, so daß die Verlustleistungen der Diode gering gehalten werden können. Andererseits ist in Durchlaßrichtung der Diode eine möglichst niedrige Flußspannung wünschenswert, so daß der Betrieb der Diode bei geringen Spannungen erfolgen kann. Zwar ist die Durchlaßspannung von Schottky-Dioden niedriger als bei üblichen pn-Dioden gleicher Fläche, jedoch ist sie nicht unabhängig von der Kapazität der Schottky-Diode. Das Verhältnis der Kapazität zur Flußspannung einer Schottky-Diode ist bei gleicher Fläche konstant. Eine kleine Kapazität und ein niedriger Sperrstrom haben eine erhöhte Flußspannung zur Folge und umgekehrt. Somit ist es problematisch mit einer Schottky-Diode gleichzeitig sehr hohen Anforderungen an eine kleine Kapazität und an eine niedrige Flußspannung gerecht zu werden. Die gleiche Problematik tritt bei allen Halbleiterbauelementen gemäß dem Oberbegriff des Patentanspruchs 1 auf.

In IEEE Transactions on microwave theory and techniques, Bd.42, Nr. 12, Dez. 94, Seiten 2504-2511, S.S. GEARHART et al., wird eine Schottky Diode mit zwei epitaxialen schichten, gemäß dem Oberbegritt des Anspruchs 1, dargestellt. Eine andere Ausführung eines Schottky-Bauelements ist aus US-A-3891479 bekannt.

Der Erfindung liegt die Aufgabe zugrunde, ein gattungsgemäßes Halbleiterbauelement zu schaffen, das eine kürzere Schaltzeit ohne Verschlechterung der Durchlaßspannung aufweist.

Diese Aufgabe wird durch ein gattungsgemäßes Halbleiterbauelement gemäß Anspruch 1 gelöst.

Bei dem erfindungsgemäßen Halbleiterbauelement wird die Kapazität gegenüber dem Halbleiterbauelement mit einer Epitaxieschicht mit gleichmäßiger Dotierung erniedrigt. Dies führt gleichzeitig zu einer Erniedrigung des Sperrstroms. Bei dem erfindungsgemäßen Halbleiterbauelement wird dabei nicht die gesamte Strom/Spannungskennlinie in unveränderter Form in Richtung höherer Spannung verschoben, wodurch die Flußspannung erhöht werden würde. Vielmehr bleibt die Flußspannung gleich, d.h. die niedrige Flußspannung wird erhalten. Dies hat den Vorteil, daß der Spannungsabfall am Ausgangswiderstand niedrig bleibt, und somit auch die ohm'sche Verlustleistung gering bleibt.

Besondere Ausführungsbeispiele der Erfindung werden in den Unteransprüchen offenbart.

Das Halbleitersubstrat, die erste und die zweite epitaxiale Schicht bestehen aus dem gleichen Material (Silizium) wobei die Dotierungskonzentration des Halbleitersubstrats höher und vom gleichen Dotierungstyp ist wie die der ersten epitaxialen Schicht. Ein besonders günstiges Verhältnis der Flußspannung zu der Kapazität der Diode wird erreicht, wenn die Dotierungskonzentration der ersten epitaxialen Schicht wenigstens doppelt so hoch ist wie die der zweiten epitaxialen Schicht. Die erste epitaxiale Schicht kann dicker, vorzugsweise doppelt so dick wie die zweite epitaxiale Schicht sein. Das Halbleitersubstrat, die erste und die zweite epitaxiale Schicht bestehen aus Silizium und die Isolierschicht kann vorteilhafterweise aus Siliziumdioxid bestehen.

Im folgenden wird die Erfindung anhand der Figur näher erläutert.
Fig. 1 zeigt einen Querschnitt durch ein erfindungsgemäßes Ausführungsbeispiel einer Schottky-Diode und
Fig. 2 zeigt die Dotierungskonzentration der epitaxialen Schichten der Schottky-Diode gemäß der Figur 1.

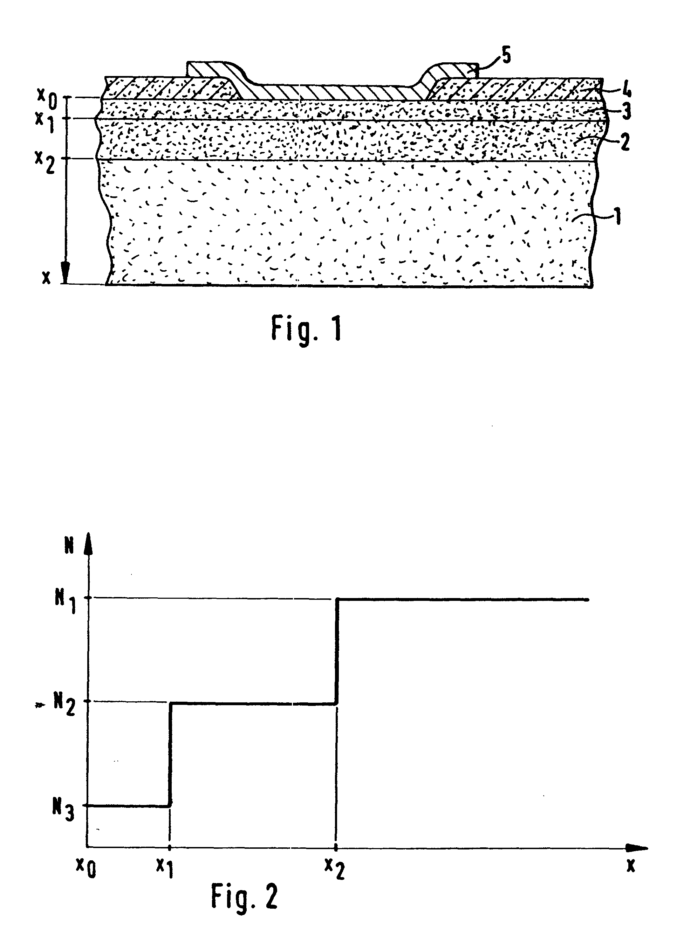

In der Figur ist als Ausführungsbeispiel des erfindungsgemäßen Halbleiterbauelements eine Schottky-Diode gezeigt. Die Schottky-Diode gemäß Fig.1 besteht aus einem Halbleitersubstrat 1, einer ersten epitaxialen Schicht 2 und einer zweiten epitaxialen Schicht 3, welche übereinander angeordnet sind. Auf der zweiten epitaxialen Schicht 2 ist eine strukturierte Isolierschicht 4 aufgebracht. Über eine Öffnung in der Isolierschicht 4 ist eine Metallschicht 5 so aufgebracht, daß sie die Öffnung und einen Teil der daran angrenzenden Isolierschicht 4 überdeckt. Die Kontaktierung dieser Schottky-Diode erfolgt an der Metallschicht 4 und an der Rückseite des Halbleitersubstrats 1.

Gemäß einem erfindungsgemäßen Ausführungsbeispiel besteht das Halbleitersubstrat 1 aus einem hoch n-dotierten Silizium, die epitaxialen Schichten 2 und 3 aus n-dotiertem Silizium, mit einer deutlich niedrigen Dotierung als das Halbleitersubstrat 1, die Isolierschicht 4 aus Siliziumdioxid und die Metallschicht aus einem für Schottky-Dioden typischen Metall beispielsweise Chrom, Molybdän oder Platin.

Die Dotierungskonzentration der ersten und der zweiten epitaxialen Schichten 2, 3 ist in Fig. 2 in Abhängigkeit der Tiefe x der epitaxialen Schichten 2 und 3, von der Oberfläche der zweiten epitaxialen Schicht 3 beginnend dargestellt. Ausgehend von der Dotierungskonzentration N₁, welche die Dotierungskonzentration des Halbleitersubstrats 1 darstellt, sinkt die Dotierungskonzentration an der Grenzfläche des Halbleitersubstrats 1 und der ersten epitaxialen Schicht 2 auf den Wert N₂, bleibt innerhalb der ersten epitaxialen Schicht 2 konstant und sinkt an der Grenzfläche zwischen der ersten epitaxialen Schicht 2 und der zweiten epitaxialen Schicht 3 auf den Wert N₃, welcher innerhalb der zweiten epitaxialen Schicht 3 konstant bleibt. In dem gezeigten Ausführungsbeispiel ist die Dotierungskonzentration des Halbleitersubstrats 1 etwa doppelt so hoch wie die Dotierungskonzentration N₂ der ersten epitaxialen Schicht 2, wobei deren Dotierungskonzentration ein Mehrfaches der Dotierungskonzentration N₃ der zweiten epitaxialen Schicht 3 beträgt. Ferner ist die Schichtdicke x₁ der zweiten epitaxialen Schicht kleiner als die Schichtdicke x₂ der ersten epitaxialen Schicht, welche kleiner ist als die Schichtdicke des Halbleitersubstrats 1. Typische Werte für die Dotierungskonzentration N₁ des Halbleitersubstrats liegen zwischen 10¹⁸cm⁻³ und 10²¹cm⁻³, für die Dotierungskonzentration N₂ der ersten epitaxialen Schicht 2 zwischen 5x10¹⁴cm⁻³ und 5x10¹⁶cm⁻³, für die Dotierungskonzentration N₃ der zweite epitaxiale Schicht 3 zwischen 10¹²cm⁻³ und einem Wert, der kleiner ist als der Wert N₂. Ein typischer Wert für die Schichtdicke der ersten epitaxialen Schicht liegt zwischen 2µm und 50µm.

## Patentansprüche

1. Halbleiterbauelement mit einem Substrat (1) und einer darauf aufgebrachten Epitaxieschicht, auf welcher eine strukturierte Isolierschicht (4) und darüber eine Metallschicht (5) derart angeordnet sind, daß die Metallschicht mit der Epitaxieschicht einen Metall-Halbleiterkontakt bildet, wobei die Epitaxieschicht eine erste und eine zweite epitaxiale Schicht (2, 3) umfaßt, wobei die erste, an das Halbleitersubstrat (1) angrenzende, epitaxiale Schicht eine höhere Dotierungskonzentration vom gleichen Dotierungstyp aufweist als die zweite epitaxiale Schicht (3), wobei die Dotierungskonzentration innerhalb der beiden epitaxialen Schichten (2, 3) jeweils konstant bleibt **dadurch gekennzeichnet,** daß das Substrat (1), die erste und die zweite epitaxiale Schicht (2, 3) aus Silizium bestehen und daß die Dotierungskonzentration des Substrats (1) höher und vom gleichen Dotierungstyp ist wie die der ersten epitaxialen Schicht (2).

2. Halbleiterbauelement nach Anspruch 1, **dadurch gekennzeichnet**, daß die Dotierungskonzentration der ersten epitaxialen Schicht (2) wenigstens doppelt so hoch ist wie die der zweiten epitaxialen Schicht (3).

3. Halbleiterbauelement nach Anspruch 1 oder 2, **dadurch gekennzeichnet**, daß die erste epitaxiale Schicht (2) dicker ist als die zweite epitaxiale Schicht (3).

4. Halbleiterbauelement nach einem der Ansprüche 1 bis 3, **dadurch gekennzeichnet**, daß die erste epitaxiale Schicht (2) doppelt so dick ist wie die zweite epitaxiale Schicht(3).

5. Halbleiterbauelement nach einem der Ansprüche 1 bis 4, **dadurch gekennzeichnet**, daß die Isolierschicht (4) aus Siliziumdioxid besteht.

6. Halbleiterbauelement nach einem der Ansprüche 1 bis 5, **dadurch gekennzeichnet**, daß die Dotierungskonzentration in dem Substrat (1) zwischen 10¹⁸ cm⁻³ und 10²¹ cm⁻³ liegt, die Dotierungskonzentration in der ersten epitaxialen Schicht (2) zwischen 5 x 10¹⁴ cm⁻³ und 5 x 10¹⁶ cm⁻³ liegt, und die Dotierungskonzentration in der zweiten epitaxialen Schicht (3) zwischen 10¹² cm⁻³ und einem Wert liegt, der kleiner ist als der der Dotierungskonzentration in der ersten epitaxialen Schicht (2),

## Claims

1. A semiconductor component having a substrate (1) with an epitaxy layer applied thereupon, on which a structured insulating layer (4) and a superimposed metal layer (5) are arranged such that the metal layer forms a metal-semiconductor contact with the epitaxy layer, the epitaxy layer comprising a first and a second epitaxial layer (2, 3), wherein the first epitaxial layer, adjacent to the semiconductor substrate (1), has a higher doping concentration of the same doping type than the second epitaxial layer (3), with the doping concentration within each of the two epitaxial layers (2, 3) being constant, **characterised in that** the substrate (1) and the first and the second epitaxial layers (2, 3) consist of silicon and that the doping concentration of the substrate (1) is higher than and of the same doping type as that of the first epitaxial layer (2).

2. The semiconductor component according to claim 1, **characterised in that** the doping concentration of the first epitaxial layer (2) is at least double that of the second epitaxial layer (3).

3. The semiconductor component according to claim 1 or 2, **characterised in that** the first epitaxial layer (2) is thicker than the second epitaxial layer (3).

4. The semiconductor component according to any of claims 1 to 3, **characterised in that** the first epitaxial layer (2) is twice as thick as the second epitaxial layer (3).

5. The semiconductor component according to any of claims 1 to 4, **characterised in that** the insulating layer (4) consists of silicon dioxide.

6. The semiconductor component according to any of claims 1 to 5, **characterised in that** the doping concentration in the substrate (1) lies between 10¹⁸ cm⁻³ and 10²¹ cm⁻³, the doping concentration in the first epitaxial layer (2) lies between 5 x 10¹⁴ cm⁻³ and 5 x 10¹⁶ cm⁻³, and the doping concentration in the second epitaxial layer (3) lies between 10¹² cm⁻³ and a value that is less than that of the doping concentration in the first epitaxial layer (2).

## Revendications

1. Composant à semi-conducteur ayant un substrat (1) et une couche d'épitaxie appliquée sur celui-ci, sur laquelle une couche d'isolation structurée (4) et une couche métallique (5) de recouvrement sont disposées de sorte que la couche métallique forme un contact métal/semi-conducteur avec la couche d'épitaxie, la couche d'épitaxie comportant une première et une deuxième couche épitaxiale (2, 3), la première couche épitaxiale adjacente au substrat à semi-conducteur (1) présentant une concentration de dopage du même type de dopage, plus élevée que celle de la deuxième couche épitaxiale (3), la concentration de dopage à l'intérieur des deux couches épitaxiales (2, 3) restant respectivement constante, **caractérisé en ce que** le substrat (1), les première et deuxième couches épitaxiales (2, 3) sont constituées de silicium et que la concentration de dopage du substrat (1) est plus élevée et du même type de dopage que celle de la première couche épitaxiale (2).

2. Composant à semi-conducteur selon la revendication 1, **caractérisé en ce que** la concentration de dopage de la première couche épitaxiale (2) est au moins deux fois supérieure à celle de la deuxième couche épitaxiale (3).

3. Composant à semi-conducteur selon la revendication 1 ou 2, **caractérisé en ce que**, la première couche épitaxiale (2) est plus épaisse que la deuxième couche épitaxiale (3).

4. Composant à semi-conducteur selon l'une quelconque des revendications 1 à 3, **caractérisé en ce que** la première couche épitaxiale (2) est deux fois plus épaisse que la deuxième couche épitaxiale (3).

5. Composant à semi-conducteur selon l'une quelconque des revendications 1 à 4, **caractérisé en ce que** la couche d'isolation (4) est constituée de dioxyde de silicium.

6. Composant à semi-conducteur selon l'une quelconque des revendications 1 à 5, **caractérisé en ce que** la concentration de dopage dans le substrat (1) est comprise entre 10¹⁸ cm⁻³ et 10²¹ cm⁻³, la concentration de dopage dans la première couche épitaxiale (2) est comprise entre 5 x 10¹⁴ cm⁻³ et 5 x 10¹⁸ cm⁻³ et la concentration de dopage dans la deuxième couche épitaxiale (3) est comprise entre 10¹² cm⁻³ et une valeur qui est inférieure à celle de la concentration de dopage dans la première couche épitaxiale (2).
